# EUROPEAN PATENT SPECIFICATION

(11) **EP 3 154 198 B1**
(45) Date of publication and mention of the grant of the patent: **22.05.2019**
(21) Application number: 16192233.1
(22) Date of filing: 04.10.2016
(51) Int. Cl.: H03K 17/0812, H01L 27/02, H02H 9/04

(54) **CLIPPING CIRCUIT**
BEGRENZERSCHALTUNG
CIRCUIT DE FIXATION

(30) Priority: 09.10.2015 BE 201505649
(43) Date of publication of application: 12.04.2017
(73) Proprietor: Sofics BVBA, 9880 Aalter (BE)
(72) Inventor: Backers, Ilse Paula Maria, 8680 Koekelare (BE); Marichal, Olivier, 9100 Sint-Niklaas (BE); Van Wijmeersch, Sven, 9000 Gent (BE)
(74) Representative: D'Halleweyn, Nele Veerle Trees Gertrudis

(56) References cited:
- WO-A1-2013/083767
- US-A- 5 321 597
- US-A1- 2011 279 934

## Description

### Field of Invention

The field of the invention relates to clipping circuits. Particular embodiments relate to the field of clipping circuits for receiving circuitry, and to electronic chips comprising receiving circuitry and a clipping circuit.

### Background

Communication is very often done through wireless connections. Antennas are used to send and receive signals. Examples are radio frequency identification (RFID) applications or near field communication (NFC) applications. A problem for receivers using such communication technology is that the received power (voltage, current) depends on the power from the sender and on the distance from the sender to the receiver. Also other sources may introduce noise or peak voltages. If the receiver is a CMOS chip design the maximum voltage at the pin is very often limited to a few volts, e.g. 1-5V. If the voltage becomes too high/low the normal operation of the chip may change or even the chip may be destroyed. To that end the power (voltage or current) has to be limited.

In the prior art, diode clipping circuits are used for a variety of applications to modify an input waveform using diodes or to provide over-voltage protection using Zener diodes to ensure that the output voltage does not exceed a certain value. Such circuits have the disadvantage of having a limited flexibility and efficiency.

US 2011/0279934 A1 discloses a structure for protecting an integrated circuit connected to first and second rails of a differential link against overvoltages, including: a first bidirectional conducting device, between the first rail and a common node; a second bidirectional conducting device, between the second rail and the common node; and a capacitor between the common node and a low reference potential rail.

WO 2013/0083767 A1 discloses an electrostatic discharge (ESD) protection circuit including at least a clamping device, a switching device, and a voltage limiter. The ESD protection circuit may include devices of different voltage domains. The switching device may be in series with the clamping device to block at least a portion of a voltage from dropping across the clamping device. The switching device may sustain higher maximum operating voltages than the clamping device.

US 5 321 597 discloses a galvanic isolation device including a transformer and a reversible switch.

### Summary

The object of embodiments of the invention is to provide a clipping circuit which is more efficient and flexible compared to prior art solutions.

According to a first aspect of the invention there is provided a clipping circuit according to claim 1. The clipping circuit comprises: a shunting circuit and a separate voltage control circuit. The shunting circuit is configured to conduct a current between a first node and a second node. The voltage control circuit is configured to cause a current to flow in said shunting circuit from the first node to the second node, when a voltage difference between said first node and said second node exceeds a predetermined first threshold voltage; and to cause a current to flow in said shunting circuit from the second node to the first node, when a voltage difference between said second node and said first node exceeds a predetermined second threshold voltage.

By providing the clipping circuit with a shunting circuit and a separate voltage control circuit to control the current flow in the shunting circuit, the clipping can be done very efficiently. Also, the difference between the value of the voltage between the first and the second node at the beginning of the clipping, i.e. when the clipping circuit starts to conduct, and the value at the maximum current conduction of the clipping circuit can be small compared to prior art solutions using one or more diodes.

The first and second node may be a signal pin like an input, an output, or an input/output. An exemplary implementation may be a differential in- and/or output pin where the first node is coupled to one of the differential pins and the second node is coupled to the other differential pin. An alternative configuration may be that the first node is coupled to a signal pin and that the second node is coupled to a power or ground pin. A third exemplary implementation may be that clipping circuit is coupled between two power pins, e.g. between a first power supply connected to the first node and a second power supply connected to the second node, or between a first power supply connected to the first node and a ground pin connected to the second node.

The voltage control circuit comprises a first voltage control branch and a second control branch. The first control branch is configured to cause a current to flow in said shunting circuit from the first node to the second node, when a voltage difference between said first node and said second node exceeds the predetermined first threshold voltage. The second voltage control branch is configured to cause a current to flow in said shunting circuit from the second node to the first node, when a voltage difference between said second node and said first node exceeds the predetermined second threshold voltage. By having a first and a second voltage control branch the voltage can be efficiently clipped in both directions.

In an exemplary embodiment the shunting circuit comprises a first controllable switching element connected to be controlled by the first voltage control branch, and a second controllable switching element connected to be controlled by the second voltage control branch. The first and second controllable switching elements may be first and second field effect transistors connected in series between the first node and the second node.

The first voltage control branch comprises a first resistive circuit in series with voltage limiting circuitry, wherein a first intermediate node between the first resistive circuit and the voltage limiting circuitry is connected to the shunting circuit; and the second voltage control branch comprises a second resistive circuit in series with the voltage limiting circuitry, wherein a second intermediate node between the second resistive circuit and the voltage limiting circuitry is connected to the shunting circuit. The voltage limiting circuitry is configured and connected to limit the voltage difference (V1-V2) between the first node and the second node, when said voltage difference exceeds the predetermined first threshold voltage and to limit the voltage difference (V2-V1) between the second node and the first node, when said voltage difference exceeds the predetermined second threshold voltage.

In an exemplary embodiment the voltage limiting circuitry comprises a first voltage limiter connected to the first resistive circuit, and a separate second voltage limiter connected to the second resistive circuit. Such an embodiment has the advantage that the first threshold voltage may be different from the second threshold voltage. In another exemplary embodiment the voltage limiting circuitry comprises common voltage limiting circuitry connected to the first resistive circuit and to the second resistive circuit. Such an embodiment has the advantage that the number of components can be limited and that the difference between the first and the second threshold voltage is limited for both directions.

The voltage limiting circuitry may comprise any one or more of the following components: a diode connected to function as a forward diode, a Zener diode, a transistor, a diode connected to function as a reverse diode. When a first and a second voltage limiter are used, each limiter may comprise any one or more of the following components: a diode connected to function as a forward diode, a Zener diode, a transistor, a diode connected to function as a reverse diode.

In an exemplary embodiment the connection between the first intermediate node and the shunting circuit is such that a voltage over the first resistive circuit controls the first controllable switching element; and/or the connection between the second intermediate node and the shunting circuit is such that a voltage over the second resistive circuit controls the second controllable switching element.

In an exemplary embodiment the clipping circuit further comprises in the first voltage control branch a first circuit for creating a unidirectional flow from the first node to the second node, and in the second voltage control branch a second circuit for creating a unidirectional flow from the second node to the first node. With the expression "creating a unidirectional flow", it is meant that when the first or second circuit operates in a normal operation mode, current can only flow in one direction, whilst in the other direction only a very small leakage current can flow. Because of the voltage clipping between the first and the second node those first and second circuits will not be allowed to go in breakdown, so that they can fulfill their function of ensuring a unidirectional flow in the first and second voltage control branch. In other embodiments this function may be performed by the first and second voltage limiter.

In an exemplary embodiment the clipping circuit further comprises an enabling circuit configured to enable and disable at least partially the operation of the clipping circuit. Such an enabling circuit will make it possible to disable the clipping function for certain applications.

The enabling circuit may comprise an enabling device configured to enable and disable the operation of the voltage control circuitry. In a further embodiment the enabling circuit comprises a first enabling device configured to enable and disable the operation of the first voltage control branch and/or a second enabling device configured to enable and disable the operation of the second voltage control branch. The first enabling device may be a first switching device in the first voltage control branch, e.g. connected in series with the first voltage limiter or included in the first voltage limiter, and/or the second enabling device may be a second switching device in the second voltage control branch, e.g. connected in series with the second voltage limiter or included in the second voltage limiter. In another embodiment the first enabling device is a first switching device connected in parallel with the first resistive circuit and/or the second enabling device is a second switching device connected in parallel with the second resistive circuit.

In an exemplary embodiment the shunting circuit is further configured to conduct a current between the first node and a third node; and the voltage control circuit is further configured to cause a current to flow in said shunting circuit from the first node to the third node, when a voltage difference between said first node and said third node exceeds a predetermined third threshold voltage. The voltage control circuit may then be further configured to cause a current to flow in said shunting circuit from the third node to the first node, when a voltage difference between said third node and said first node exceeds a predetermined fourth threshold voltage.

In a further embodiment with three nodes, the voltage control circuit comprises a third voltage control branch configured to cause a current to flow in said shunting circuit from the first node to the third node, when a voltage difference between said first node and said third node exceeds a predetermined third threshold voltage; and a fourth voltage control branch configured to cause a current to flow in said shunting circuit from the third node to the first node, when a voltage difference between said third node and said first node exceeds a predetermined fourth threshold voltage.

In a further embodiment with three nodes the shunting circuit is further configured to conduct a current between the second node and the third node; and the voltage control circuit is further configured to cause a current to flow in said shunting circuit from the second node to the third node, when a voltage difference between said second node and said third node exceeds a predetermined fifth threshold voltage; and to cause a current to flow in said shunting circuit from the third node to the second node, when a voltage difference between said third node and said second node exceeds a predetermined sixth threshold voltage.

In a further embodiment with three nodes the voltage control circuit comprises a fifth voltage control branch configured to cause a current to flow in said shunting circuit from the second node to the third node, when a voltage difference between said second node and said third node exceeds a predetermined fifth threshold voltage; and a sixth voltage control branch configured to cause a current to flow in said shunting circuit from the third node to the second node, when a voltage difference between said third node and said second node exceeds a predetermined sixth threshold voltage.

In an exemplary embodiment the clipping circuit is a circuit designed with NMOS or PMOS MOSFET devices. In an exemplary embodiment the first and second controllable switching elements are first and second NMOS devices connected in series between the first node and the second node, or the first and second controllable switching elements are first and second PMOS devices connected in series between the first node and the second node.

According to another aspect of the invention, there is provided an electronic chip comprising receiving circuitry for receiving an external signal and a clipping circuit according to any one of the previous embodiments. The receiving circuitry may comprise an antenna.

### Brief description of the figures

The accompanying drawings are used to illustrate presently preferred non-limiting exemplary embodiments of devices of the present invention. The above and other advantages of the features and objects of the invention will become more apparent and the invention will be better understood from the following detailed description when read in conjunction with the accompanying drawings, in which:
Figures 1A, 1B and 1C are circuit diagrams of three generic exemplary embodiments of a clipping circuit;
Figures 2A, 2B, 2C are circuit diagrams of three exemplary variants of the embodiment of figure 1A with different voltage limiters;
Figures 3A and 3B are circuit diagrams of two exemplary embodiments with enabling circuit;
Figures 4A, 4B, and 4C are circuit diagrams of three further exemplary embodiments with enabling circuit;
Figures 5A and 5B are circuit diagrams of two exemplary embodiments with common voltage limiting circuitry and a common enabling circuit for the first and second voltage control branches;
Figure 6 is a circuit diagram of an exemplary embodiment with additional gate protection circuits;
Figure 7 is a circuit diagram of a first exemplary embodiment of a clipping circuit with three pins;
Figure 8 is a circuit diagram of a second exemplary embodiment of a clipping circuit with three pins;
Figure 9 is a schematic diagram of a first exemplary embodiment of an electronic chip with a clipping circuit; and
Figure 10 is a chart plotting the current from a first node to a second node in function of the voltage between the first node and the second node.

### Description of embodiments

Elements indicated in the figures are numbered in the following format XYYY, with X the figure number and YYY the specific number for a part of the figures. For the different figures, similar elements have the same YYY number. Variations described for a certain number YYY in one figure apply also for the other figures.

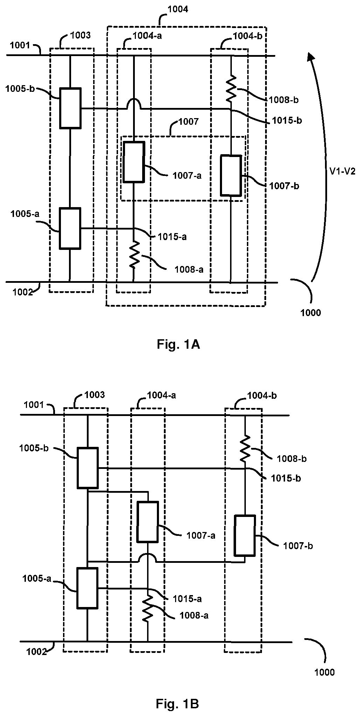

Figure 1A depicts an embodiment of a clipping circuit 1000 coupled between first node 1001 and second node 1002. First and second nodes 1001 and 1002 may be a signal pin like an input pin, an output pin, or an input/output pin. The term "input/output pin" refers to a pin that is able to function both as an input pin and as an output pin. E.g. the following combination are possible: input pin 1001 and input pin 1002; input pin 1001 and output pin 1002; output pin 1001 and output pin 1002; input/output pin 1001 and input/output pin 1002; input/output pin 1001 and input pin 1002; and input/output pin 1001 and output pin 1002. An exemplary implementation may be a differential in- and/or output pin where first node 1001 is coupled to one of the differential pins and second node 1002 is coupled to the other differential pin. An alternative configuration may be that one of the two nodes 1001, 1002 is coupled to a signal pin and that the other one is coupled to a power pin, e.g. a power supply, a ground, etc. A third exemplary implementation may be that clipping circuit 1000 is coupled between two power pins, e.g. between a first power supply pin connected to first node 1001 and a second power supply pin connected to second node 1002, or between a first power supply pin connected to first node 1001 and a ground pin connected to second node 1002.

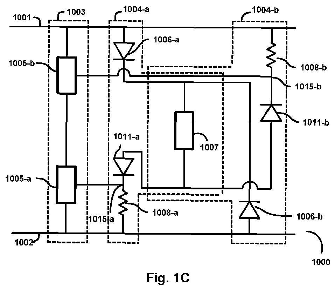

Clipping circuit 1000 comprises a shunting circuit 1003, and a voltage control circuit 1004. Shunting circuit 1003 is configured to conduct a current between a first node 1001 and a second node 1002. Voltage control circuit 1004 comprises a first voltage control branch 1004a configured to cause a current to flow in shunting circuit 1003 from first node 1001 to second node 1002, when a voltage difference (V1 - V2) between first node 1001 and second node 1002 exceeds a predetermined first threshold voltage (V1 - V2 > Vth1); and a second voltage control branch 1004b configured to cause a current to flow in shunting circuit 1003 from second node 1002 to first node 1001, when a voltage difference (V2 - V1) between second node 1002 and first node 1001 exceeds a predetermined second threshold voltage (V2 - V1 > Vth2). The first threshold voltage (Vth1) may be the same as or different from the second threshold voltage (Vth2), e.g. depending on the application for which clipping circuit 1000 is used. The first voltage control branch 1004a and the second voltage control branch 1004b may be separate voltage control branches as drawn in figure 1A, or may have certain common components, see also the embodiment of figure 1C which will be discussed below.

In other words, voltage control circuit 1004 will set a minimum threshold voltage Vth1 between node 1001 and node 1002, and a minimum threshold Vth2 between node 2 and node 1. When the voltage difference (V1-V2) reaches Vth1 or when (V2-V1) reaches Vth2, shunting circuit 1003 may be turned on to conduct current to limit the voltage between first node 1001 and second node 1002, i.e. the voltage begins to be clipped when V1-V2 ≈ Vth1 or V2-V1 ≈ Vth2, depending on the direction of the current. As long as the threshold voltage for both directions is not reached shunting circuit 1003 may not conduct current.

Shunting circuit 1003 comprises a first controllable switching element 1005a connected to be controlled by the first voltage control branch 1004a, and a second controllable switching element 1005b connected to be controlled by the second voltage control branch 1004b. The first and second controllable switching elements 1005a, 1005b are preferably connected in series, and may be e.g. first and second transistors connected in series between first node 1001 and second node 1002. In a preferred embodiment the transistors are MOSFETs, but the person skilled in the art understand that other types of field effect transistors or bipolar transistors may also be used in embodiments of the invention. In an exemplary embodiment, the first and second controllable switching elements 1005a, 1005b are both NMOS devices. In another exemplary embodiment, the first and second controllable switching elements 1005a, 1005b are both PMOS devices.

First voltage control branch 1004a comprises a first resistive circuit 1008a in series with a first voltage limiter 1007a of voltage limiting circuitry 1007. A first intermediate node 1015a between first resistive circuit 1008a and first voltage limiter 1007a is connected to the shunting circuit 1003, and in particular to first controllable switching element 1005a. Second voltage control branch 1004b comprises a second resistive circuit 1008b in series with a second voltage limiter 1007b of voltage limiting circuitry 1007. A second intermediate node 1015b between second resistive circuit 1008b and second voltage limiter 1007b is connected to the shunting circuit 1003, and in particular to second controllable switching element 1005b. Voltage limiter 1007a is configured and connected to limit the voltage difference (V1-V2) between first node 1001 and second node 1002, when said voltage difference exceeds the predetermined first threshold voltage (Vth1). Voltage limiter 1007b is configured and connected to limit the voltage difference (V2-V1) between second node 1002 and first node 1001, when said voltage difference exceeds the predetermined second threshold voltage (Vth2).

In figure 1A first and second voltage control branches 1004a and 1004b are connected between first node 1001 and second node 1002. Figure 1B illustrates a variant of the embodiment of figure 1A which is similar, with this difference that first and second voltage control branches 1004a and 1004b are connected to an intermediate node 1016 between first controllable switching element 1005a and second controllable switching element 1005b. More in particular, first voltage control branch 1004a is connected between intermediate node 1016 and second node 1002, and second voltage control branch 1004b is connected between first node 1001 and intermediate node 1016. The embodiment of figure 1B may be useful if it is desirable to limit the capacitive load on the first and second nodes 1001, 1002.

Figure 1C illustrates another variant of the embodiment of figure 1A. In the embodiment of figure 1C first voltage control branch 1004a and second voltage control branch 1004b have common voltage limiting circuitry 1007. First voltage control branch 1004a comprises a first resistive circuit 1008a, a diode 1011a, voltage limiting circuitry 1007, and a further diode 1006a, connected in series. First intermediate node 1015a between first resistive circuit 1008a and diode 1011a is connected to first controllable switching element 1005a. Second voltage control branch 1004b comprises a second resistive circuit 1008b, a diode 1011b, voltage limiting circuitry 1007, and a further diode 1006b, connected in series. Second intermediate node 1015b between second resistive circuit 1008b and diode 1011b is connected to second controllable switching element 1005b. Diodes 1011a and 1011b will avoid that the first and second resistive circuits 1008a and 1008b are connected in series between first node 1001 and second node 1002, and hence will avoid that more than a leakage current flows between the first node 1001 and the second node 1002 when the voltage limiting circuitry 1007 is in a non-conducting state. Diode 1006a and diode 1006b connect the first node 1001 and the second node 1002 to the voltage limiting circuitry 1007, respectively. Further, diodes 1006a and 1006b will ensure that the current flow is unidirectional. For example, if a positive voltage difference (V1-V2) is present between first node 1001 and second node 1002, the first threshold voltage is determined by diode 1006a, voltage limiting circuitry 1007, diode 1011a and first controllable switching element 1005a, and apart from a leakage current, there will be no current flow through diode 1006b, diode 1011b and second resistive circuit 1008b. Similarly, if a positive voltage difference (V2-V1) is present between second node 1002 and first node 1001, the second threshold voltage is determined by diode 1006b, voltage limiting circuitry 1007, diode 1011b and second controllable switching element 1005b, and apart from a leakage current, there will be no current flow through diode 1006a, diode 1011a and second resistive circuit 1008a. The person skilled in the art understands that, in stead of using diodes 1006a, 1006b, also other electronic circuits for creating a unidirectional flow, e.g. suitably connected MOSFETs, may be used to fulfill the function of avoiding current flow in reverse direction in the voltage control branches 1004a, 1004b. Also diodes 1011a and 1011b may be replaced by other electronic components fulfilling the same function, e.g. suitably connected MOSFETs.

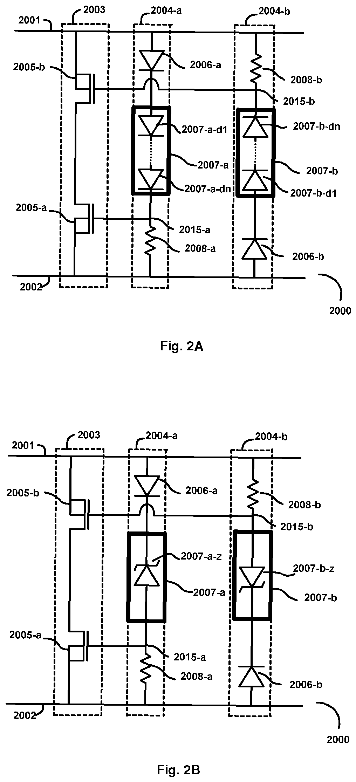

Figure 2A illustrates another exemplary embodiment of a clipping circuit 2000. Clipping circuit 2000 of figure 2A is similar to the embodiment of figure 1A and comprises a shunting circuit 2003, and a voltage control circuit with a first voltage control branch 2004a and a second voltage control branch 2004b. Shunting circuit 2003 comprises a first controllable switching element 2005a connected to be controlled by first voltage control branch 2004a, and a second controllable switching element 2005b connected to be controlled by second voltage control branch 2004b. In the embodiment of figure 2A, the controllable switching elements 2005a, 2005b, also called shunting elements comprise an NMOS device. A person skilled in the art understands that the controllable switching elements may comprise at least one of a NMOS, a PMOS, a cascoded NMOS, a cascoded PMOS a NPN, a PNP, JFET, SCR, etc. Further, the first controllable switching element 2005a may be identical to or different from the second controllable switching element 2005b. First controllable switching element 2005a is designed for current conduction from first node 2001 towards second node 2002, if the voltage difference (V2 - V1) exceeds the minimum threshold voltage Vth1 defined by first voltage control branch 2004a. In this situation the second control branch 2004b controls second controllable switching element 2005b such that this element also conducts. Hence current will flow in the shunting circuit 2003 from node 2001 to node 2002, and the voltage difference will be clipped. A similar reasoning applies when the voltage difference (V1 - V2) exceeds the minimum threshold voltage Vth2 defined by second voltage control branch 2004b.

First voltage control branch 2004a comprises a series connection of a first resistive circuit 2008a, a first voltage limiter 2007a comprising a plurality of diodes 2007adl...2007adn connected in series, and a diode 2006a. First intermediate node 2015a between first resistive circuit 2008a and first voltage limiter 2007a is connected to first controllable switching element 2005a. Second voltage control branch 2004b comprises a series connection of a second resistive circuit 2008b, a second voltage limiter 2007b comprising a plurality of diodes 2007bdl...2007bdn connected in series, and a diode 2006b. Second intermediate node 2015b between second resistive circuit 2008b and second voltage limiter 2007b is connected to second controllable switching element 2005b.

Diode 2006a and the plurality of diodes 2007adl...2007adn ensure a unidirectional flow in the first control branch 2004a from first node 2001 to second node 2002. Similarly, diode 2006b and the plurality of diodes 2007bdl...2007bdn ensure a unidirectional flow in the second control branch 2004b, from second node 2002 to first node 2001. For example, if a positive stress (V1-V2) is present between first node 2001 and second node 2002, the first threshold voltage is determined by the components in the first voltage control branch 2004a, and at most a leakage current flows in second voltage control branch 2004b.

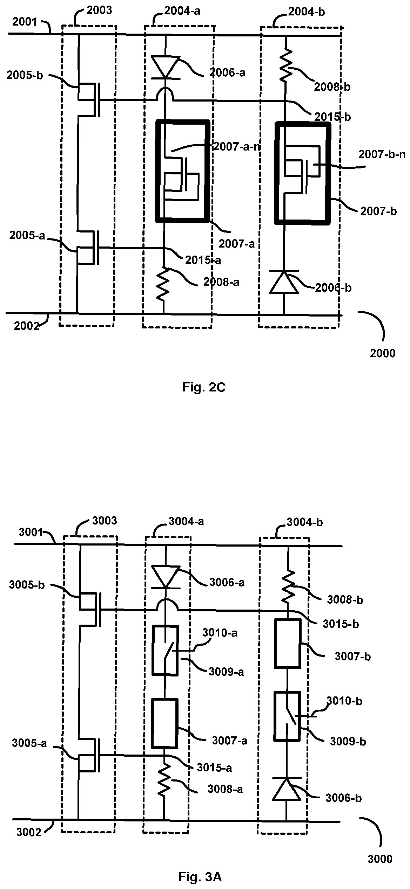

As explained in connection with figure 1C, in stead of using diodes 2006a, 2006b, also other electronic circuits for creating a unidirectional flow, e.g. suitably connected MOSFETs, may be used. Also, since in the embodiment of figure 2 forward conducting diodes are used to realize the first and second voltage limiters 2007a, 2007b, the unidirectional flow in the voltage control branches 2004a, 2004b is already guaranteed, and hence diodes 2006a and 2006b may be omitted. Or, stated differently any electronic circuits for creating a unidirectional flow may be part of the voltage limiters 2007a, 2007b.
The first voltage limiter 2007a will determine the minimum threshold voltage Vth1 when the shunting device 2003 may be turned on. In the embodiment of figure 2A, the first voltage limiter 2007a comprises a plurality of diodes 2007ad1...2007adn connected in series, but the skilled person understands that the first voltage limiter 2007a may comprise alternatively or in addition a reverse diode, a MOS transistor, a bipolar transistor, etc. First voltage limiter 2007a is designed such that no current will flow below a certain threshold voltage Vth1 and that current will flow above this threshold voltage Vth1. When the voltage between node 2001 and node 2002 is above this threshold voltage Vth1, current will flow through the first voltage limiter 2007a and so through the resistive circuit 2008a. The resistive circuit 2008a may comprise a resistor or another circuit functioning as a resistive element such as a transistor, a diode, etc. The current flow through resistive circuit 2008a will create a voltage drop over 2008a. Resistive circuit 2008a is coupled to shunting circuit 2003, and in particular to a control input, corresponding with intermediate node 2015a, of the first switchable control element 2005a, here a MOSFET device 2005a. The induced voltage drop will turn on the shunting circuit 2003. In the embodiment as depicted in figure 2A, the resistive circuit 2008a is coupled to the gate of the MOSFET device 2005a. A voltage drop over the resistive circuit 2008a will forward the gate source of the MOSFET device 2005a, turning the MOSFET device 2005a is a conducting state. Note that at this moment the current may flow from first node 2001 to second node 2002: MOSFET device 2005a is in a conducting mode and the drain-bulk diode of MOSFET transistor 2005b is forward biased.
In figure 2A, forward diodes 2007adl...2007adn, 2007bdl...2007bdn are used for the first and second voltage limiters 2007a, 2007b. The number of diodes will determine the turn-on voltage, i.e. the voltage at which current starts to flow in the respective first and second voltage control branches 2004a, 2004b. This turn-on voltage will be equal to the total number of diodes including the diode 2006a, 2006b multiplied with the forward built-in voltage of a diode. For example if voltage limiters 2007a, 2007b each comprise three diodes and unidirectional circuits each comprise one diode 2006a, 2006b, current may flow if the voltage between the first node 2001 and second node 2002 is above Vturn-on1 = Vturn-on2 = (3+1) x 0.7 V = 2.8 V, wherein it is assumed that the forward built-in voltage of a diode is 0.7 V. Typically the built-in voltage of the diode will be between 0.65 V and 0.8 V. From this point current will flow and when the voltage over the resistive circuit 2008a, 2008b is above the threshold voltage of the MOSFET device 2005a, 2005b, current will start to flow through the shunting circuit 2003. The first and second threshold voltages are in this example: Vth1 = Vth2 = Vturn-on1 + VT1 = Vturn-on2 + VT2 = 2.8 V + VT, wherein VT is the threshold voltage of the MOSFET devices 2005a, 2005b, i.e. the gate-source voltage for which the MOSFET device becomes conductive.

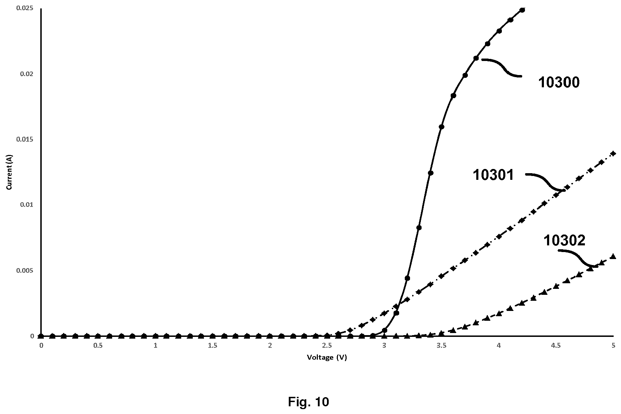

An advantage of the exemplary embodiment of figure 2A is that the first and second threshold voltage Vth1, Vth2 can be set independent of the current flow, to limit the voltage between the first node 2001 and the second node 2002. This allows a smaller difference between the first/second threshold voltage Vth1, Vth2 and the actual clipping voltage (maximum current flow), compared to prior art solutions. This is illustrated in figure 10. Figure 10 plots the current between a first node and a second node in function of the voltage difference (V2-V1) between the first node and the second node for:
- an exemplary embodiment of a clipping circuit of figure 2A with three diodes 2006a, 2007adl, 2007ad2 in the first voltage control branch 2004a, with three diodes 2006b, 2007bdl, 2007bd2 in the second voltage control branch 2004b, and with a first and second MOSFET device as the first and second controllable switching element, see curve 10300;
- a first prior clipping circuit consisting of three diodes connected in series between a first node and a second node, see curve 10301; and
- a second clipping circuit consisting of four diodes connected in series between a first node and a second node, see curve 10302.

For curve 10300 the threshold voltage is Vth1 = Vth2 ≈ 3*0.7 V + VT ≈ 3*0.7 V + 0.6 V ≈ 2.7 V (note that the current is shown on a linear scale, and that therefor the small amount of current that flows when V2-V1 is between 2.7 V and 2.8 V is hardly visible for curve 10300 in figure 10). For simplicity reasons it has been assumed in this example that the built-in voltage is 0.7 V and that the threshold voltage of a MOSFET is 0.6 V but the skilled person understands that in practice these values will not be exactly 0.7 V and 0.6 V. Also, these values will be dependent on the method used to calculate these values. Further, this is merely an example, and in other exemplary embodiments the built-in voltage and the threshold voltage may be different, e.g. 0.8 V and 0.5 V respectively. The current (which flows through the shunting circuit 2003 and through one of the voltage control branches 2004a or 2004b) increases rapidly above this threshold voltage, so that the actual clipping voltage, e.g. the voltage at a maximum current flow of 0.01 A, here approximately 3.3V, is not much higher than the threshold voltage of approximately 2.7 V. For curve 10301 the threshold voltage is Vth ≈ 3*0.7 V ≈ 2.1 V (note that the current is shown on a linear scale, and that therefor the small amount of current that flows when V2-V1 is between 2.1 V and 2.5 V is not visible for curve 10301 in figure 10). The current (which flows through the series connection of the three diodes) increases above this threshold voltage but not as rapidly as for curve 30100. The actual clipping voltage, e.g. the voltage at a maximum current flow of 0.01 A, here more than 4V, is much higher than the threshold voltage of approximately 2.1 V. For curve 10302 the threshold voltage is Vth ≈ 4*0.7 V ≈ 2.8 V. The current (which flows through the series connection of the four diodes) increases above this threshold voltage but not as rapidly as for curve 30100. The actual clipping voltage, e.g. the voltage at a maximum current flow of 0.01 A, here more than 5 V, is much higher than the threshold voltage of approximately 2.8 V. This comparative measurement example illustrates that there is a smaller difference between the first/second threshold voltage Vth1, Vth2 and the actual clipping voltage (at a maximum current flow) compared to prior art solutions.

Figures 2B and 2C depict exemplary embodiments similar to the embodiment of figure 2A but with other voltage limiters 2007a, 2007b. In figure 2B voltage limiters 2007a, 2007b each comprise a reverse diode or a Zener diode 2007az, 2007bz. When the reverse breakdown voltage of diode 2007az, 2007bz is reached, the current starts to flow in the respective voltage control branches 2004a, 2004b. The voltage limiters 2007a, 2007b may also comprise multiple reverse diodes in series to achieve higher breakdown voltages. In figure 2C voltage limiters 2007a, 2007b each comprise a MOSFET device 2007an, 2007bn (NMOS or PMOS). In this example the gate of MOSFET device 2007an, 2007bn is coupled to the source thereof. When the drain-bulk diode starts the avalanche the NPN inside the MOS can be turned on and conduct current.

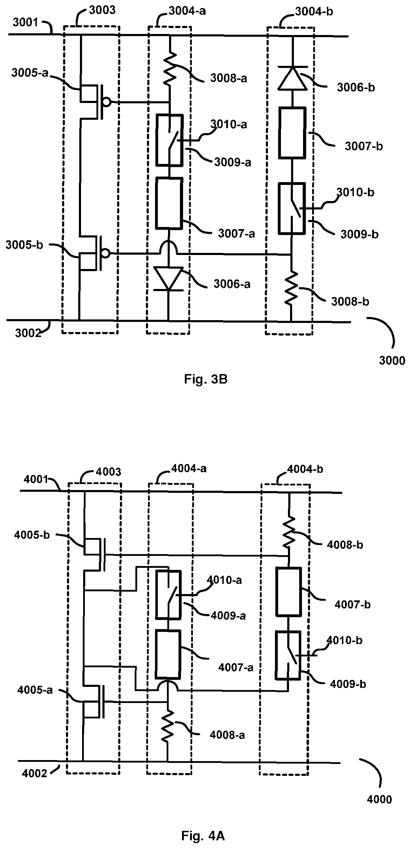

Figures 3A and 3B illustrate two exemplary embodiments of a clipping circuit 3000 with enabling circuit 3009a, 3009b configured to enable and disable at least partially the operation of the clipping circuit 3000, and in particular to enable and disable the operation of the voltage control circuitry 3004a, 3004b. The enabling circuit 3009a comprises a first enabling device 3010a configured to enable and disable the operation of the first voltage control branch 3004a and a second enabling device 3010b configured to enable and disable the operation of the second voltage control branch 3004b. In another embodiment only one of the voltage control branches 3004a, 3004b may be provided with an enabling circuit 3009a, 3009b. The first enabling device 3010a may be a first switching device connected in series with the first voltage limiter 3007a, and the second enabling device 3010b may be a second switching device connected in series with the second voltage limiter 3007b.

Sometimes the first and/or second node 3001, 3002, e.g. IO pins, can have different operation modes depending on the application or time. For example a pin can be used to be a transceiver and receiver at the same time or a pin be can reprogrammed during development or operation. The clipping may not always be desired, depending on the application, so the clipping circuit can be disabled by adding enabling circuits 3009a, 3009b. Enabling circuits 3009a, 3009b may comprise as enabling device 3010a, 2013b any one of the following, or a combination thereof: a single MOSFET device (NMOS, PMOS), a passgate, a bipolar transistor, etc. Depending on the input signal on a control pin of the enabling circuits 3009a, 3009b, the voltage control branch 3004a, 3004b can be activated or not. When a branch 3004a, 3004b is deactivated, a signal between first node 3001 and second node 3002 will not be seen over voltage limiter 3007a, 3007b. So it will not turn on. When enabling circuit 3009a, 3009b is enabled the voltage will be seen over voltage limiter 3007a, 3007b and the clipping circuit 3000 can be turned on when the voltage exceeds the respective threshold voltages Vth1 or Vth2.

Figure 3A shows an embodiment with two NMOS devices as first and second controllable switching elements 2005a, 2005b. Figure 3B shows an alternative embodiment with two PMOS devices as first and second controllable switching elements 2005a, 2005b.

In the embodiments of figures 3A and 3B the first and second enabling circuit 3009a, 3009b are arranged in the first and second voltage control branch 3004a, 3004b, in series with the first and second voltage limiter 3007a, 3007b, respectively. In non-illustrated exemplary variants the first enabling circuit 3009a may be included between the first node 3001 and the diode 3006a, or in the first and second voltage limiter 3007a, e.g. between two diodes of the first voltage limiter, and more generally in any suitable position in the first voltage control branch 3004a. The same applies for the second enabling circuit 3009b. In these embodiments the first and second voltage control branch 3004a, 3004b are provided between the first node 3001 and the second node 3002.

Figure 4A shows an alternative embodiment, similar to the embodiment of figure 1B, wherein the first and second enabling circuit 4009a, 4009b are arranged in the first and second voltage control branch 4004a, 4004b, in series with the first and second voltage limiter 4007a, 4007b, respectively, and wherein the first and second voltage control branches 4004a and 4004b are connected to an intermediate node 4016 between first controllable switching element 4005a and second controllable switching element 4005b. In the embodiment of Figure 4A the bulk-drain diode of the MOSFET devices 4005a, 4005b may be used. This embodiment is possible if the combination of the voltage limiter 4007a and enabling circuit 4009a and the combination of voltage limiter 4007b and enabling circuit 4009 are unidirectional, such that reverse breakdown or current conduction may only start at higher voltages. An advantage of this embodiment is that the capacitive loading at first node 4001 and at second node 4002 is lower because no diodes are needed in the first and second voltage control branch 4004a, 4004b.

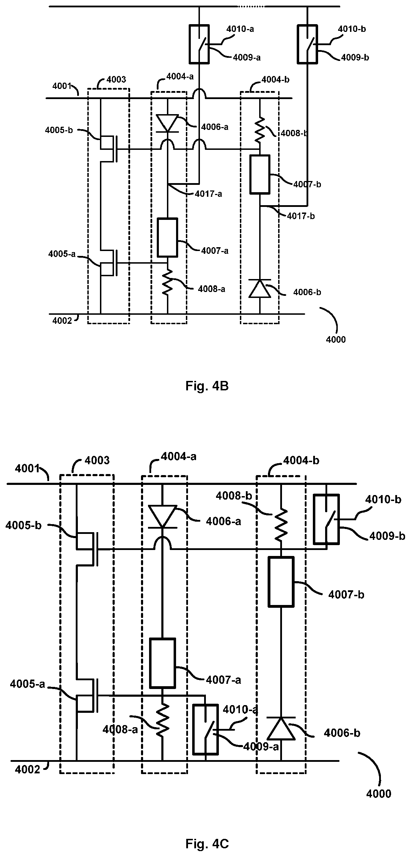

Alternative ways to couple the enabling circuit 4009a, 4009b are depicted in figures 4B and 4C. In the embodiment of figure 4B an intermediate node 4017a, 4017b between voltage limiter 4007a, 4007b and unidirectional circuit 4006a, 4006b is pulled to a voltage reference potential, e.g. a ground voltage or a power supply voltage. This will cause that the potential over the voltage limiter 4007a, 4007b is at a fixed potential. If this fixed potential is such that the turn-on voltage of unidirectional circuit 4006a, 4006b is not reached, the clipping circuit 4000 will remain disabled. A second alternative clipping circuit 4000 with enabling circuit 4009a, 4009b is depicted in figure 4C. In this embodiment the resistive circuit 4008a, 4008b is shunted by the enabling circuit 4009a, 4009b. By shunting resistive circuit 4008a, 4008b, the path between the gate of controllable switching element 4005a, 4005b and its source will be low resistive, making controllable switching element 4005a, 4005b more difficult to turn on. Stated differently, more current is needed to reach the threshold voltage Vth1 or Vth2.

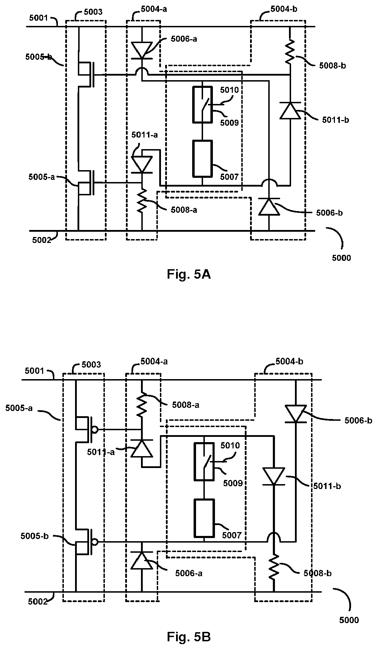

Figures 5A and 5B depict an embodiment of a clipping circuit 5000, similar to the embodiment of figure 1C, but where, in series with the voltage limiting circuitry 5007, also an enabling circuit 5009 is shared between the first and the second voltage control branch 5004a, 5004b. Note that additional diodes 5011a, 5511b are provided to prevent a leakage path between first node 5001 and second node 5002 through resistive circuits 5008a and 5008b, as in the embodiment of figure 1C. Figure 5A shows an embodiment with two NMOS devices as first and second controllable switching elements 5005a, 5005b. Figure 5B shows an alternative embodiment with two PMOS devices as first and second controllable switching elements 5005a, 5005b.

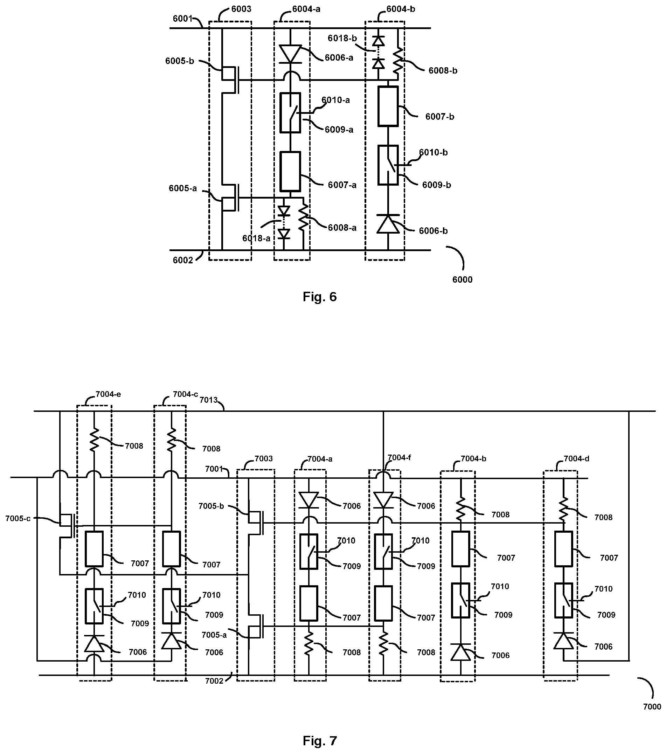

Figure 6 illustrates an exemplary embodiment similar to the embodiment of figure 3A, but with an additional gate protection circuit 6018a, 6018b in parallel with the resistive circuit 6008a, 6008b. A series of forward diodes is used, but other gate protection circuits can also be used, such as any one or more of the following, or a combination thereof: reverse diode, Zener diode, MOSFET device. For certain applications too much current may flow through resistive circuit 6008a, 6008b. If controllable switching element 6005a, 6005b is a MOSFET device, the gate oxide of the latter could be damaged between gate and source/bulk. By adding a gate protection circuit 6018a, 6018b this may be prevented.

Embodiments of the invention are not limited to clipping circuits with two pins. More than two pins are equally possible. An exemplary embodiment of a clipping circuit 7000 with three pins is illustrated in figure 7. The clipping circuit 7000 has a first portion between first node 7001 and second node 7002, a second portion between first node 7001 and third node 7013, and a third portion between second node 7002 and third node 7013. First, second and third nodes 7001, 7002 and 7013 may be a signal pin like an input, an output, or an input/output. Clipping circuit 7000 comprises a shunting circuit 7003, and a voltage control circuit 7004a, 7004b, 7004c, 7004d, 7004e, 7004f. Shunting circuit 7003 is configured to conduct a current between first node 7001 and second node 7002, between first node 7001 and third node 7013, and between second node 7002 and third node 7013. Voltage control circuit comprises between the first node 7001 and the second node 7002 a first voltage control branch 7004a configured to cause a current to flow in shunting circuit 7003, when a voltage difference between the first node 7001 and the second node 7002 exceeds a predetermined first threshold voltage Vth1; and a second voltage control branch 7004b configured to cause a current to flow in shunting circuit 7003, when a voltage difference between the second node 7002 and the first node 7001 exceeds a predetermined second threshold voltage Vth2. Voltage control circuit comprises between the first node 7001 and the third node 7003 a third voltage control branch 7004c configured to cause a current to flow in shunting circuit 7003, when a voltage difference between the first node 7001 and the third node 7013 exceeds a predetermined third threshold voltage Vth3; and a fourth voltage control branch 7004d configured to cause a current to flow in shunting circuit 7003, when a voltage difference between the third node and the first node exceeds a predetermined fourth threshold voltage Vth4. Voltage control circuit comprises between the second node 7002 and the third node 7013 a fifth voltage control branch 7004e configured to cause a current to flow in shunting circuit 7003, when a voltage difference between the second node 7001 and the third node 7013 exceeds a predetermined fifth threshold voltage Vth5; and a sixth voltage control branch 7004f configured to cause a current to flow in shunting circuit 7003, when a voltage difference between the third node and the second node exceeds a predetermined sixth threshold voltage Vth6. The first, second, third, fourth, fifth and sixth threshold voltages Vth1, Vth2, Vth3, Vth4, Vth5, Vth6 of the various voltage control branches 7004a, 7004b, 7004c, 7004d, 7004e, 7004f may be the same or different.

Shunting circuit 7003 comprises a first controllable switching element 7005a connected to be controlled by the voltage control branches 7004a, 7004f, a second controllable switching element 7005b connected to be controlled by the voltage control branches 7004b, 7004d, and a third controllable switching element 7005c connected to be controlled by the voltage control branches 7004c, 7004e. Preferably, the first and second controllable switching elements 7005a, 7005b are connected in series between first node 7001 and second node 7002, first and third controllable switching elements 7005a, 7005c are connected in series between first node 7001 and third node 7013, and second and third controllable switching elements 7005b, 7005c are connected in series between second node 7002 and third node 7013, such that there is a common intermediate node 7016. The controllable switching elements 7005a, 7005b, 7005c may be e.g. MOSFETs.

Each voltage control branch 7004a, 7004b, 7004c, 7004d, 7004e, 7004f comprises a series connection of a resistive circuit 7008, voltage limiting circuitry 7007, an enabling circuit 7009 and a diode 7006. A first intermediate node between resistive circuit 7008 and voltage limiting circuitry 7007 is connected to a controllable switching element 7005a, 7005b, 7005c in similar manner as described before for the embodiments with two pins. The skilled person understands that the various exemplary embodiments described for two pins can be easily extended to embodiments with more than two pins. Further, depending on the application, in embodiments with three pins, there may be provided four voltage control branches instead of six, e.g. two branches between the first node and the second node, two branches between the first node and the third node, and no branches between the second node and the third node. In an embodiment with 4 pins there may be provided e.g. twelve voltage control branches.

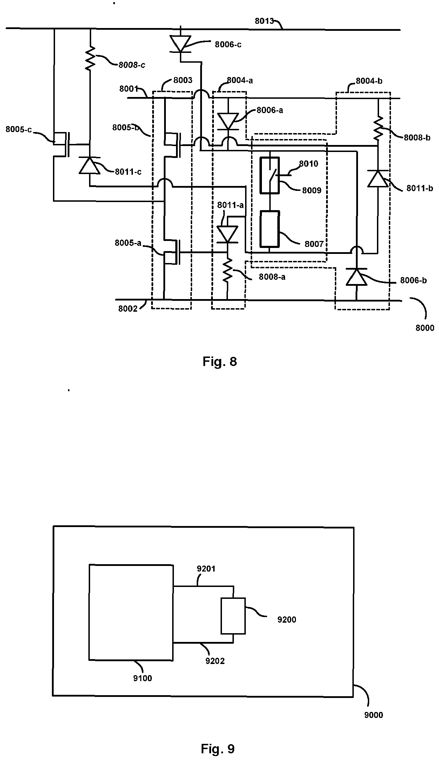

Another exemplary embodiment of a clipping circuit 8000 with three pins is illustrated in figure 8. Clipping circuit 8000 comprises a shunting circuit 8003, and a voltage control circuit 8004a, 8004b, 8004c. This embodiment uses common voltage limiting circuitry 8007 and a common enabling circuit 8009, and is similar to the embodiment of figure 5A with two pins. Voltage control circuit comprises between the first node 8001 and the second node 8002 a first voltage control branch 8004a configured to cause a current to flow in shunting circuit 8003, when a voltage difference between the first node 8001 and the second node 8002 exceeds a predetermined first threshold voltage Vth1; and a second voltage control branch 8004b configured to cause a current to flow in shunting circuit 8003, when a voltage difference between the second node 8002 and the first node 8001 exceeds a predetermined second threshold voltage Vth2. Voltage control circuit comprises between the first node 8001 and the third node 8003 a third voltage control branch configured to cause a current to flow in shunting circuit 8003, when a voltage difference between the first node 8001 and the third node 8013 exceeds a predetermined third threshold voltage Vth3, etc. Because of the common voltage limiting circuitry 8007 less components are needed for creating six control branches. In such an embodiment the first, second, third, fourth, fifth and sixth threshold voltages Vth1, Vth2, Vth3, Vth4, Vth5, Vth6 of the various voltage control branches 8004a, 8004b, etc. are typically the same.

Shunting circuit 8003 comprises a first controllable switching element 8005a, a second controllable switching element 8005b, and a third controllable switching element 8005c. The first and second controllable switching elements 8005a, 8005b are connected in series between first node 8001 and second node 8002, first and third controllable switching elements 8005a, 8005c are connected in series between first node 8001 and third node 8013, and second and third controllable switching elements 8005b, 8005c are connected in series between second node 8002 and third node 8013, such that there is a common intermediate node 8016. The controllable switching elements 8005a, 8005b, 8005c may be e.g. MOSFETs.

Each possible voltage control branch 8004a, 8004b, etc. comprises a series connection of a resistive circuit 8008a, 8008b, 8008c, voltage limiting circuitry 8007, an enabling circuit 8009, a diode 8006a, 8006b, 8006c, and a diode 8011a, 8011b, 8011c. An intermediate node between resistive circuit 8008a, 8008b, 8008c and diode 8011a, 8011b, 8011c is connected to a controllable switching element 8005a, 8005b, 8005c in similar manner as described before for the embodiments with two pins, see e.g. figure 5A.

Figure 9 illustrates schematically an electronic chip 9000 comprising a receiving circuitry 9100 for receiving an external signal e.g. wirelessly via an antenna or via a cable, and a clipping circuit 9200 according to any one of the previous embodiments, coupled between a first node 9201 and a second node 9202 of the receiving circuitry 9100. The electronic chip 9000 may be a multi-purpose input output (IO) unit with one or more inputs and one or more outputs, wherein one or more embodiments of clipping circuits of the invention may be used, in particular embodiments with one or more enabling circuits. Other examples are a reprogrammable IO unit, a reconfigurable IO unit.

Yet other examples of electronic chips are wireless receivers such as an RFID chip, an NFC chip, a Bluetooth chip, a Wi-Fi chip; or wired input and/or output chips, such as a USB chip, an HDMI chip, etc.

Whilst the principles of the invention have been set out above in connection with specific embodiments, it is to be understood that this description is merely made by way of example and not as a limitation of the scope of protection which is determined by the appended claims.

## Claims

1. A clipping circuit comprising:
a shunting circuit (1003) configured to conduct a current between a first node (1001) and a second node (1002);
a separate voltage control circuit, the voltage control circuit (1004) being configured
to cause a current to flow in said shunting circuit from the first node to the second node, when a voltage difference between said first node and said second node exceeds a predetermined first threshold voltage; and
to cause a current to flow in said shunting circuit from the second node to the first node,
when a voltage difference between said second node and said first node exceeds a predetermined second threshold voltage; wherein the voltage control circuit comprises:
a first voltage control branch (1004a) configured to cause a current to flow in said shunting circuit from the first node to the second node, when a voltage difference between said first node and said second node exceeds the predetermined first threshold voltage;
a second voltage control branch (1004b) configured to cause a current to flow in said shunting circuit from the second node to the first node, when a voltage difference between said second node and said first node exceeds the predetermined second threshold voltage,
**characterised in that** the first voltage control branch (1004a) comprises a first resistive circuit (1008a) in series with voltage limiting circuitry (1007), wherein a first intermediate node (1015a) between the first resistive circuit and the voltage limiting circuitry (1007) is connected to the shunting circuit (1003); and
**in that** the second voltage control branch (1004b) comprises a second resistive circuit (1008b) in series with the voltage limiting circuitry (1007), wherein a second intermediate node (1015b) between the second resistive circuit and the voltage limiting circuitry (1007) is connected to the shunting circuit (1003),
and wherein the voltage limiting circuitry (1007) is configured and connected to limit the voltage difference (V1-V2) between the first node (1001) and the second node (1002), when said voltage difference exceeds the predetermined first threshold voltage and to limit the voltage difference between second node and the first node (V2-V1), when said voltage difference exceeds the predetermined second threshold voltage.

2. The clipping circuit of claim 1, wherein the shunting circuit comprises a first controllable switching element (1005a) connected to be controlled by the first voltage control branch (1004a), and a second controllable switching element (1005b) connected to be controlled by the second voltage control branch (1004b).

3. The clipping circuit of claim 2, wherein the first and second controllable switching elements (1005a, 1005b) are first and second NMOS devices connected in series between the first node and the second node; or wherein the first and second controllable switching elements are first and second PMOS devices connected in series between the first node and the second node.

4. The clipping circuit of claim 2 or 3, wherein the connection between the first intermediate node (1015a) and the shunting circuit (1003) is such that a voltage over the first resistive circuit (1008a) controls the first controllable switching element (1005a); and/or wherein the connection between the second intermediate node (1015b) and the shunting circuit (1003) is such that a voltage over the second resistive circuit (1008b) controls the second controllable switching element (1005b).

5. The clipping circuit of claim 1 or 4, wherein the voltage limiting circuitry (1007) comprises a first voltage limiter (1007a) connected to the first resistive circuit (1008a), and a separate second voltage limiter (1007b) connected to the second resistive circuit (1008b).

6. The clipping circuit of claim 1 or 4, wherein the voltage limiting circuitry (1007) comprises common voltage limiting circuitry connected to the first resistive circuit (1008a) and to the second resistive circuit (1008b).

7. The clipping circuit of any one of the claims 1 or 4 to 6, wherein the voltage limiting circuitry (1007) comprises any one or more of the following components: a diode connected to function as a forward diode, a Zener diode, a transistor, a diode connected to function as a reverse diode.

8. The clipping circuit of any one of the claims 1 to 7, further comprising in the first voltage control branch (1004a) a first circuit (1006a) for creating a unidirectional flow from the first node to the second node, and in the second voltage control branch (1004b) a second circuit (1006b) for creating a unidirectional flow from the second node to the first node.

9. The clipping circuit of any one of the previous claims, further comprising an enabling circuit (4009a, 4009b; 5009; 6009a, 6009b; 7009; 8009) configured to enable and disable at least partially the operation of the clipping circuit; wherein the enabling circuit comprises an enabling device configured to enable and disable the operation of the voltage control circuitry.

10. The clipping circuit of claim 1 and 9, wherein the enabling circuit comprises a first enabling device (4009a; 6009a) configured to enable and disable the operation of the first voltage control branch (4004a; 6004a); and/or a second enabling device (4009b; 6009b) configured to enable and disable the operation of the second voltage control branch (4004b; 6004b); wherein the first enabling device (4009a; 6009a) is a first switching device connected in series with the first voltage limiter (4007a; 6007a); and/or wherein the second enabling device (4009b; 6009b) is a second switching device connected in series with the second voltage limiter (4007b; 6007b); and/or wherein the first enabling device (4009a) is a first switching device connected in parallel with the first resistive circuit (4008a); and/or wherein the second enabling device (4009b) is a second switching device connected in parallel with the second resistive circuit (4008b).

11. The clipping circuit of any one of the previous claims, wherein the shunting circuit (7003) is further configured to conduct a current between the first node (7001) and a third node (7013); and wherein the voltage control circuit is further configured to cause a current to flow in said shunting circuit (7003) from the first node (7001) to the third node (7013), when a voltage difference between said first node and said third node exceeds a predetermined third threshold voltage; wherein the voltage control circuit is further configured to cause a current to flow in said shunting circuit (7003) from the third node (7013) to the first node (7001), when a voltage difference between said third node and said first node exceeds a predetermined fourth threshold voltage; and wherein the voltage control circuit comprises:
a third voltage control branch (7004c) configured to cause a current to flow in said shunting circuit (7003) from the first node to the third node, when a voltage difference between said first node and said third node exceeds a predetermined third threshold voltage;
a fourth voltage control branch (7004d) configured to cause a current to flow in said shunting circuit (7003) from the third node to the first node, when a voltage difference between said third node and said first node exceeds a predetermined fourth threshold voltage.

12. The clipping circuit of claim 11, wherein the shunting circuit (7003) is further configured to conduct a current between the second node (7002) and the third node (7013); and
wherein the voltage control circuit is further configured
to cause a current to flow in said shunting circuit (7003) from the second node (7002) to the third node (7013), when a voltage difference between said second node and said third node exceeds a predetermined fifth threshold voltage; and
to cause a current to flow in said shunting circuit (7003) from the third node (7013) to the second node (7002), when a voltage difference between said third node and said second node exceeds a predetermined sixth threshold voltage; and wherein the voltage control circuit comprises:
a fifth voltage control branch (7004e) configured to cause a current to flow in said shunting circuit (7003) from the second node to the third node, when a voltage difference between said second node and said third node exceeds a predetermined fifth threshold voltage;
a sixth voltage control branch (7004f) configured to cause a current to flow in said shunting circuit (7003) from the third node to the second node, when a voltage difference between said third node and said second node exceeds a predetermined sixth threshold voltage.

13. An electronic chip (9000) comprising receiving circuitry (9100) for receiving an external signal and a clipping circuit (9200) according to any one of the previous claims.

## Patentansprüche

1. Begrenzerschaltung, die aufweist:
eine Nebenschlussschaltung (1003), die konfiguriert ist, um einen Strom zwischen einem ersten Knoten (1001) und einem zweiten Knoten (1002) zu leiten;
eine getrennte Spannungssteuerschaltung, wobei die Spannungssteuerschaltung (1004) konfiguriert ist, um
zu bewirken, dass ein Strom in der Nebenschlussschaltung von dem ersten Knoten zu dem zweiten Knoten fließt, wenn eine Spannungsdifferenz zwischen dem ersten Knoten und dem zweiten Knoten eine vorgegebene erste Schwellspannung überschreitet; und
zu bewirken, dass ein Strom in der Nebenschlussschaltung von dem zweiten Knoten zu dem ersten Knoten fließt, wenn eine Spannungsdifferenz zwischen dem zweiten Knoten und dem ersten Knoten eine vorgegebene zweite Schwellspannung überschreitet;
wobei die Spannungssteuerschaltung aufweist:
einen ersten Spannungssteuerzweig (1004a), der konfiguriert ist, um zu bewirken, dass ein Strom in der Nebenschlussschaltung von dem ersten Knoten zu dem zweiten Knoten fließt, wenn eine Spannungsdifferenz zwischen dem ersten Knoten und dem zweiten Knoten die vorgegebene erste Schwellspannung überschreitet;
einen zweiten Spannungssteuerzweig (1004b), der konfiguriert ist, um zu bewirken, dass ein Strom in der Nebenschlussschaltung von dem zweiten Knoten zu dem ersten Knoten fließt, wenn eine Spannungsdifferenz zwischen dem zweiten Knoten und dem ersten Knoten die vorgegebene zweite Schwellspannung überschreitet,
**dadurch gekennzeichnet, dass**
der erste Spannungssteuerzweig (1004a) eine erste Widerstandsschaltung (1008a) in Reihe mit einer Spannungsbegrenzungsschaltungsanordnung (1007) aufweist, wobei ein erster Zwischenknoten (1015a) zwischen der ersten Widerstandsschaltung und der Spannungsbegrenzungsschaltungsanordnung (1007) mit der Nebenschlussschaltung (1003) verbunden ist; und
dass der zweite Spannungssteuerzweig (1004b) eine zweite Widerstandsschaltung (1008b) in Reihe mit der Spannungsbegrenzungsschaltungsanordnung (1007) aufweist, wobei ein zweiter Zwischenknoten (1015b) zwischen der zweiten Widerstandsschaltung und der Spannungsbegrenzungsschaltungsanordnung (1007) mit der Nebenschlussschaltung (1003) verbunden ist,
und wobei die Spannungsbegrenzungsschaltungsanordnung (1007) konfiguriert und angeschlossen ist, um die Spannungsdifferenz (V1 - V2) zwischen dem ersten Knoten (1001) und dem zweiten Knoten (1002) zu begrenzen, wenn diese Spannungsdifferenz die vorgegebene erste Schwellspannung überschreitet, und die Spannungsdifferenz zwischen dem zweiten Knoten und dem ersten Knoten (V2 - V1) zu begrenzen, wenn diese Spannungsdifferenz die vorgegebene zweite Schwellspannung überschreitet.

2. Begrenzerschaltung nach Anspruch 1, wobei die Nebenschlussschaltung aufweist: ein erstes steuerbares Schaltelement (1005a), das angeschlossen ist, um von dem ersten Spannungssteuerzweig (1004a) gesteuert zu werden, und ein zweites steuerbares Schaltelement (1005b), das angeschlossen ist, um von dem zweiten Spannungssteuerzweig (1004b) gesteuert zu werden.

3. Begrenzerschaltung nach Anspruch 2, wobei die ersten und zweiten steuerbaren Schaltelemente (1005a, 1005b) erste und zweite NMOS-Vorrichtungen sind, die in Reihe zwischen den ersten Knoten und den zweiten Knoten geschaltet sind; oder wobei die ersten und zweiten steuerbaren Schaltelemente erste und zweite PMOS-Vorrichtungen sind, die in Reihe zwischen den ersten Knoten und den zweiten Knoten geschaltet sind.

4. Begrenzerschaltung nach Anspruch 2 oder 3, wobei die Verbindung zwischen dem ersten Zwischenknoten (1015a) und der Nebenschlussschaltung (1003) derart ist, dass eine Spannung über der ersten Widerstandsschaltung (1008a) das erste steuerbare Schaltelement (1005a) steuert; und/oder wobei die Verbindung zwischen dem zweiten Zwischenknoten (1015b) und der Nebenschlussschaltung (1003) derart ist, dass eine Spannung über der zweiten Widerstandsschaltung (1008b) das zweite steuerbare Schaltelement (1005b) steuert.

5. Begrenzerschaltung nach Anspruch 1 oder 4, wobei die Spannungsbegrenzungsschaltungsanordnung (1007) einen ersten Spannungsbegrenzer (1007a), der mit der ersten Widerstandsschaltung (1008a) verbunden ist, und einen getrennten zweiten Spannungsbegrenzer (1007b), der mit der zweiten Widerstandsschaltung (1008b) verbunden ist, aufweist.

6. Begrenzerschaltung nach Anspruch 1 oder 4, wobei die Spannungsbegrenzungsschaltungsanordnung (1007) eine allgemeine Spannungsbegrenzungsschaltungsanordnung aufweist, die mit der ersten Widerstandsschaltung (1008a) und mit der zweiten Widerstandsschaltung (1008b) verbunden ist.

7. Begrenzerschaltung nach einem der Ansprüche 1 oder 4 bis 6, wobei die Spannungsbegrenzungsschaltungsanordnung (1007) eine oder mehrere der folgenden Komponenten aufweist: eine Diode, die angeschlossen ist, um als eine Vorwärtsdiode zu arbeiten, eine Zener-Diode, einen Transistor, eine Diode, die angeschlossen ist, um als eine Rückwärtsdiode zu arbeiten.

8. Begrenzerschaltung nach einem der Ansprüche 1 bis 7, die ferner aufweist: in dem ersten Spannungssteuerzweig (1004a) eine erste Schaltung (1006a) zum Erzeugen eines Flusses in einer Richtung von dem ersten Knoten zu dem zweiten Knoten, und in dem zweiten Spannungssteuerzweig (1004b) eine zweite Schaltung (1006b) zum Erzeugen eines Flusses in einer Richtung von dem zweiten Knoten zu dem ersten Knoten.

9. Begrenzerschaltung nach einem der vorhergehenden Ansprüche, die ferner eine Freigabeschaltung (4009a, 4009b; 5009; 6009a, 6009b; 7009; 8009) aufweist, die konfiguriert ist, um den Betrieb der Begrenzerschaltung wenigstens teilweise zu aktivieren und zu deaktivieren; wobei die Freigabeschaltung eine Freigabevorrichtung aufweist, die konfiguriert ist, um den Betrieb der Spannungssteuerschaltung zu aktivieren und zu deaktivieren.

10. Begrenzerschaltung nach Anspruch 1 und 9, wobei die Freigabeschaltung aufweist: eine erste Freigabevorrichtung (4009a; 6009a), die konfiguriert ist, um den Betrieb des ersten Spannungssteuerzweigs (4004a; 6004a) zu aktivieren und zu deaktivieren; und/oder eine zweite Freigabevorrichtung (4009b; 6009b), die konfiguriert ist, um den Betrieb des zweiten Spannungssteuerzweigs (4004b; 6004b) zu aktivieren und zu deaktivieren; wobei die erste Freigabevorrichtung (4009a; 6009a) eine erste Schaltvorrichtung ist, die in Reihe mit dem ersten Spannungsbegrenzer (4007a; 6007a) geschaltet ist; und/oder wobei die zweite Freigabevorrichtung (4009b; 6009b) eine zweite Schaltvorrichtung ist, die in Reihe mit dem zweiten Spannungsbegrenzer (4007b; 6007b) geschaltet ist; und/oder wobei die erste Freigabevorrichtung (4009a) eine erste Schaltvorrichtung ist, die parallel zu der ersten Widerstandsschaltung (4008a) geschaltet ist; und/oder wobei die zweite Freigabevorrichtung (4009b) eine zweite Schaltvorrichtung ist, die parallel zu der zweiten Widerstandsschaltung (4008b) geschaltet ist.

11. Begrenzerschaltung nach einem der vorhergehenden Ansprüche, wobei die Nebenschlussschaltung (7003) ferner konfiguriert ist, um einen Strom zwischen dem ersten Knoten (7001) und einem dritten Knoten (7013) zu leiten; und wobei die Spannungssteuerschaltung ferner konfiguriert ist, um zu bewirken, dass ein Strom in der Nebenschlussschaltung (7003) von dem ersten Knoten (7001) zu dem dritten Knoten (7013) fließt, wenn eine Spannungsdifferenz zwischen dem ersten Knoten und dem dritten Knoten eine vorgegebene dritte Spannungsschwelle überschreitet; wobei die Spannungssteuerschaltung ferner konfiguriert ist, um zu bewirken, dass ein Strom in der Nebenschlussschaltung (7003) von dem dritten Knoten (7013) zu dem ersten Knoten (7001) fließt, wenn eine Spannungsdifferenz zwischen dem dritten Knoten und dem ersten Knoten eine vorgegebene vierte Spannungsschwelle überschreitet; und wobei die Spannungssteuerschaltung aufweist:
einen dritten Spannungssteuerzweig (7004c), der konfiguriert ist, um zu bewirken, dass ein Strom in der Nebenschlussschaltung (7003) von dem ersten Knoten zu dem dritten Knoten fließt, wenn eine Spannungsdifferenz zwischen dem ersten Knoten und dem dritten Knoten eine vorgegebene dritte Schwellspannung überschreitet;
einen vierten Spannungssteuerzweig (7004d), der konfiguriert ist, um zu bewirken, dass ein Strom in der Nebenschlussschaltung (7003) von dem dritten Knoten zu dem ersten Knoten fließt, wenn eine Spannungsdifferenz zwischen dem dritten Knoten und dem ersten Knoten eine vorgegebene vierte Schwellspannung überschreitet.

12. Begrenzerschaltung nach Anspruch 11, wobei die Nebenschlussschaltung (7003) ferner konfiguriert ist, um einen Strom zwischen dem zweiten Knoten (7002) und dem dritten Knoten (7013) zu leiten; und
wobei die Spannungssteuerschaltung ferner konfiguriert ist, um
zu bewirken, dass ein Strom in der Nebenschlussschaltung (7003) von dem zweiten Knoten (7002) zu dem dritten Knoten (7013) fließt, wenn eine Spannungsdifferenz zwischen dem zweiten Knoten und dem dritten Knoten eine vorgegebene fünfte Spannungsschwelle überschreitet; und
zu bewirken, dass ein Strom in der Nebenschlussschaltung (7003) von dem dritten Knoten (7013) zu dem zweiten Knoten (7002) fließt, wenn eine Spannungsdifferenz zwischen dem dritten Knoten und dem zweiten Knoten eine vorgegebene sechste Spannungsschwelle überschreitet; und wobei die Spannungssteuerschaltung aufweist:
einen fünften Spannungssteuerzweig (7004e), der konfiguriert ist, um zu bewirken, dass ein Strom in der Nebenschlussschaltung (7003) von dem zweiten Knoten zu dem dritten Knoten fließt, wenn eine Spannungsdifferenz zwischen dem zweiten Knoten und dem dritten Knoten eine vorgegebene fünfte Spannungsschwelle übersteigt;
einen sechsten Spannungssteuerzweig (7004f), der konfiguriert ist, um zu bewirken, dass ein Strom in der Nebenschlussschaltung (7003) von dem dritten Knoten zu dem zweiten Knoten fließt, wenn eine Spannungsdifferenz zwischen dem dritten Knoten und dem zweiten Knoten eine vorgegebene fünfte Spannungsschwelle übersteigt.

13. Elektronischer Chip (9000), der eine Empfangsschaltungsanordnung (9100) zum Empfangen eines externen Signals und eine Begrenzerschaltung (9200) nach einem der vorhergehenden Ansprüche aufweist.

## Revendications

1. Circuit de fixation comprenant :
un circuit de shunt (1003) configuré pour conduire un courant entre un premier noeud (1001) et un deuxième noeud (1002) ;
un circuit de commande de tension séparé, le circuit de commande de tension (1004) étant configuré
pour amener un courant à s'écouler dans ledit circuit de shunt du premier noeud vers le deuxième noeud, lorsqu'une différence de tension entre ledit premier noeud et ledit deuxième noeud excède une première tension de seuil prédéterminée ; et
pour amener un courant à s'écouler dans ledit circuit de shunt du deuxième noeud vers le premier noeud, lorsqu'une différence de tension entre ledit deuxième noeud et ledit premier noeud excède une deuxième tension de seuil prédéterminée ; dans lequel le circuit de commande de tension comprend :
une première branche de commande de tension (1004a) configurée pour amener un courant à s'écouler dans ledit circuit de shunt du premier noeud vers le deuxième noeud, lorsqu'une différence de tension entre ledit premier noeud et ledit deuxième noeud excède la première tension de seuil prédéterminée ;
une deuxième branche de commande de tension (1004b) configurée pour amener un courant à s'écouler dans ledit circuit de shunt du deuxième noeud vers le premier noeud, lorsqu'une différence de tension entre ledit deuxième noeud et ledit premier noeud excède la deuxième tension de seuil prédéterminée,
**caractérisé en ce que**
la première branche de commande de tension (1004a) comprend un premier circuit résistif (1008a) en série avec des circuits de limitation de tension (1007), dans lequel un premier noeud intermédiaire (1015a) entre le premier circuit résistif et les circuits de limitation de tension (1007) est connecté au circuit de shunt (1003) ; et
**en ce que** la deuxième branche de commande de tension (1004b) comprend un second circuit résistif (1008b) en série avec les circuits de limitation de tension (1007), dans lequel un deuxième noeud intermédiaire (1015b) entre le second circuit résistif et les circuits de limitation de tension (1007) est connecté au circuit de shunt (1003),
et dans lequel les circuits de limitation de tension (1007) sont configurés et connectés pour limiter la différence de tension (V1-V2) entre le premier noeud (1001) et le deuxième noeud (1002),
lorsque ladite différence de tension excède la première tension de seuil prédéterminée et pour limiter la différence de tension entre le deuxième noeud et le premier noeud (V2-V1), lorsque ladite différence de tension excède la deuxième tension de seuil prédéterminée.

2. Circuit de fixation selon la revendication 1, dans lequel le circuit de shunt comprend un premier élément de commutation commandable (1005a) connecté pour être commandé par la première branche de commande de tension (1004a), et un second élément de commutation commandable (1005b) connecté pour être commandé par la deuxième branche de commande de tension (1004b).

3. Circuit de fixation selon la revendication 2, dans lequel les premier et second éléments de commutation commandables (1005a, 1005b) sont des premier et second dispositifs NMOS connectés en série entre le premier noeud et le deuxième noeud; ou dans lequel les premier et second éléments de commutation commandables sont des premier et second dispositifs PMOS connectés en série entre le premier noeud et le deuxième noeud.

4. Circuit de fixation selon la revendication 2 ou 3, dans lequel la connexion entre le premier noeud intermédiaire (1015a) et le circuit de shunt (1003) est telle qu'une tension appliquée au premier circuit résistif (1008a) commande le premier élément de commutation commandable (1005a) ; et/ou dans lequel la connexion entre le deuxième noeud intermédiaire (1015b) et le circuit de shunt (1003) est telle qu'une tension appliquée au second circuit résistif (1008b) commande le second élément de commutation commandable (1005b).

5. Circuit de fixation selon la revendication 1 ou 4, dans lequel les circuits de limitation de tension (1007) comprennent un premier limiteur de tension (1007a) connecté au premier circuit résistif (1008a), et un second limiteur de tension séparé (1007b) connecté au second circuit résistif (1008b).

6. Circuit de fixation selon la revendication 1 ou 4, dans lequel les circuits de limitation de tension (1007) comprennent des circuits de limitation de tension communs connectés au premier circuit résistif (1008a) et au second circuit résistif (1008b).

7. Circuit de fixation selon l'une quelconque des revendications 1 ou 4 à 6, dans lequel les circuits de limitation de tension (1007) comprennent un ou plusieurs des composants suivants : une diode connectée pour fonctionner en tant que diode directe, une diode Zener, un transistor, une diode connectée pour fonctionner en tant que diode inverse.

8. Circuit de fixation selon l'une quelconque des revendications 1 à 7, comprenant en outre dans la première branche de commande de tension (1004a) un premier circuit (1006a) pour créer un flux unidirectionnel du premier noeud vers le deuxième noeud, et dans la deuxième branche de commande de tension (1004b) un second circuit (1006b) pour créer un flux unidirectionnel du deuxième noeud vers le premier noeud.

9. Circuit de fixation selon l'une quelconque des revendications précédentes, comprenant en outre un circuit d'activation (4009a, 4009b ; 5009 ; 6009a, 6009b ; 7009; 8009) configuré pour activer et désactiver au moins en partie le fonctionnement du circuit de fixation ; dans lequel le circuit d'activation comprend un dispositif d'activation configuré pour activer et désactiver le fonctionnement des circuits de commande de tension.

10. Circuit de fixation selon la revendication 1 et 9, dans lequel le circuit d'activation comprend un premier dispositif d'activation (4009a ; 6009a) configuré pour activer et désactiver le fonctionnement de la première branche de commande de tension (4004a ; 6004a) ; et/ou un second dispositif d'activation (4009b ; 6009b) configuré pour activer et désactiver le fonctionnement de la deuxième branche de commande de tension (4004b ; 6004b) ; dans lequel le premier dispositif d'activation (4009a ; 6009a) est un premier dispositif de commutation connecté en série au premier limiteur de tension (4007a ; 6007a) ; et/ou dans lequel le second dispositif d'activation (4009b ; 6009b) est un second dispositif de commutation connecté en série au second limiteur de tension (4007b ; 6007b) ; et/ou dans lequel le premier dispositif d'activation (4009a) est un premier dispositif de commutation connecté en parallèle au premier circuit résistif (4008a) ; et/ou dans lequel le second dispositif d'activation (4009b) est un second dispositif de commutation connecté en parallèle au second circuit résistif (4008b).

11. Circuit de fixation selon l'une quelconque des revendications précédentes, dans lequel le circuit de shunt (7003) est en outre configuré pour conduire un courant entre le premier noeud (7001) et un troisième noeud (7013) ; et dans lequel le circuit de commande de tension est en outre configuré pour amener un courant à s'écouler dans ledit circuit de shunt (7003) du premier noeud (7001) vers le troisième noeud (7013), lorsqu'une différence de tension entre ledit premier noeud et ledit troisième noeud excède une troisième tension de seuil prédéterminée ; dans lequel le circuit de commande de tension est en outre configuré pour amener un courant à s'écouler dans ledit circuit de shunt (7003) du troisième noeud (7013) vers le premier noeud (7001), lorsqu'une différence de tension entre ledit troisième noeud et ledit premier noeud excède une quatrième tension de seuil prédéterminée ; et dans lequel le circuit de commande de tension comprend :
une troisième branche de commande de tension (7004c) configurée pour amener un courant à s'écouler dans ledit circuit de shunt (7003) du premier noeud vers le troisième noeud, lorsqu'une différence de tension entre ledit premier noeud et ledit troisième noeud excède une troisième tension de seuil prédéterminée ;
une quatrième branche de commande de tension (7004d) configurée pour amener un courant à s'écouler dans ledit circuit de shunt (7003) du troisième noeud vers le premier noeud, lorsqu'une différence de tension entre ledit troisième noeud et ledit premier noeud excède une quatrième tension de seuil prédéterminée.

12. Circuit de fixation selon la revendication 11, dans lequel le circuit de shunt (7003) est en outre configuré pour conduire un courant entre le deuxième noeud (7002) et le troisième noeud (7013) ; et dans lequel le circuit de commande de tension est en outre configuré
pour amener un courant à s'écouler dans ledit circuit de shunt (7003) du deuxième noeud (7002) vers le troisième noeud (7013), lorsqu'une différence de tension entre ledit deuxième noeud et ledit troisième noeud excède une cinquième tension de seuil prédéterminée ; et
pour amener un courant à s'écouler dans ledit circuit de shunt (7003) du troisième noeud (7013) vers le deuxième noeud (7002), lorsqu'une différence de tension entre ledit troisième noeud et ledit deuxième noeud excède une sixième tension de seuil prédéterminée ; et dans lequel le circuit de commande de tension comprend :
une cinquième branche de commande de tension (7004e) configurée pour amener un courant à s'écouler dans ledit circuit de shunt (7003) du deuxième noeud vers le troisième noeud, lorsqu'une différence de tension entre ledit deuxième noeud et ledit troisième noeud excède une sixième tension de seuil prédéterminée ;
une sixième branche de commande de tension (7004f) configurée pour amener un courant à s'écouler dans ledit circuit de shunt (7003) du troisième noeud vers le deuxième noeud, lorsqu'une différence de tension entre ledit troisième noeud et ledit deuxième noeud excède une sixième tension de seuil prédéterminée.

13. Puce électronique (9000) comprenant des circuits de réception (9100) pour recevoir un signal externe et un circuit de fixation (9200) selon l'une quelconque des revendications précédentes.
